(19) Europäisches Patentamt / European Patent Office / Office européen des brevets

(11) **EP 4 501 888 A1**

(12) **EUROPEAN PATENT APPLICATION**
published in accordance with Art. 153(4) EPC

(43) Date of publication:
**05.02.2025 Bulletin 2025/06**

(21) Application number: 23780976.9

(22) Date of filing: **30.03.2023**

(51) International Patent Classification (IPC):
$C04B\ 35/587^{(2006.01)}$    $C01B\ 21/06^{(2006.01)}$
$C04B\ 35/64^{(2006.01)}$    $H05K\ 1/03^{(2006.01)}$

(52) Cooperative Patent Classification (CPC):
**C01B 21/06; C04B 35/587; C04B 35/64; H05K 1/03**

(86) International application number:
**PCT/JP2023/013362**

(87) International publication number:
**WO 2023/190968 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.03.2022 JP 2022057848**

(71) Applicant: **Proterial, Ltd.
Tokyo 135-0061 (JP)**

(72) Inventors:
• **SHIMADA, Kei
Tokyo 135-0061 (JP)**
• **IMAMURA, Hisayuki
Tokyo 135-0061 (JP)**

(74) Representative: **Wilson Gunn
Blackfriars House
The Parsonage
5th Floor
Manchester M3 2JA (GB)**

(54) **METHOD FOR PRODUCING SILICON NITRIDE SUBSTRATE**

(57) In a case of manufacturing a silicon nitride substrate by nitriding a stacked body made of a plurality of stacked sheet-shaped molded bodies each containing silicon, productivity of the silicon nitride substrate is improved. As means for this, a method of manufacturing the silicon nitride substrate is used, the method nitriding a stacked body made of 5 or more and 20 or less stacked sheet-shaped molded bodies each having a sheet shape and containing silicon by conveying the stacked body from a carry-in port to a carry-out port in a continuous heating furnace including the carry-in port, the carry-out port, a heating unit for heating a space between the carry-in port and the carry-out port, and a nitrogen supply unit for supplying nitrogen into the space between the carry-in port and the carry-out port.

*FIG. 3*

EP 4 501 888 A1

## Description

TECHNICAL FIELD

The present invention relates to a method of manufacturing a silicon nitride substrate, and particularly to a method of manufacturing a silicon nitride substrate by nitriding and sintering a plurality of stacked sheet-shaped molded bodies mainly made of silicon powder.

BACKGROUND ART

Conventionally, ceramic circuit boards, in each of which a silicon nitride substrate, a metal circuit, and a metal heat sink are bonded, have been used in semiconductor modules, power modules, and the like.

As a method of manufacturing a silicon nitride substrate, there is a known method of providing a silicon nitride substrate by mixing raw materials made of silicon (Si) powder, a sintering aid, a binder, a solvent, and the like to prepare slurry, shaping the slurry into a sheet shape to provide a sheet-shaped molded body (green sheet), and then, degreasing, nitriding, and sintering the sheet-shaped molded body. In the degreasing, nitriding and sintering steps, a plurality of the sheet-shaped molded bodies are fed into a batch furnace while being stacked to improve productivity (see, for example, Patent Document 1).

RELATED ART DOCUMENT

PATENT DOCUMENT

Patent Document 1: Japanese Patent Application Laid-open Publication No. 2015-199657

SUMMARY OF THE INVENTION

PROBLEMS TO BE SOLVED BY THE INVENTION

However, in the nitriding step, if the number of stacked sheets of the sheet-shaped molded bodies is too large, a chain reaction may occur due to the concentration of reaction heat, and may melt the silicon. This causes a problem in the appearance of the silicon nitride substrate to be manufactured and a problem that is insufficiency of the nitriding reaction in this substrate. That is, there is a limitation to improve the productivity of the silicon nitride substrates by increasing the number of the stacked sheets in the nitriding step of the sheet-shaped molded bodies.

Accordingly, an objective of the present invention is to improve the productivity of the silicon nitride substrates.

MEANS FOR SOLVING THE PROBLEMS

A method of manufacturing a silicon nitride substrate according to one embodiment is to nitride a stacked body made of 5 or more and 20 or less stacked sheet-shaped molded bodies each having a sheet shape and containing silicon by conveying the stacked body from a carry-in port to a carry-out port in a continuous heating furnace including the carry-in port, the carry-out port, a heating unit for heating a space between the carry-in port and the carry-out port, and a nitrogen supply unit for supplying nitrogen into the space between the carry-in port and the carry-out port.

EFFECTS OF THE INVENTION

According to the method of manufacturing the silicon nitride substrate according to one embodiment, the productivity of the silicon nitride substrates is improved.

BRIEF DESCRIPTIONS OF THE DRAWINGS

[FIG. 1] is a perspective view showing a schematic configuration of a nitriding treatment furnace in an embodiment;
[FIG. 2] is a plan view showing a stacked body made of a plurality of sheet-shaped molded bodies and a case in the embodiment;
[FIG. 3] is a cross-sectional view taken along a line A-A in FIG. 2;
[FIG. 4] is a plan view showing an example of a conveying mode of the stacked body in the embodiment;

[FIG. 5] is a plan view showing an example of a conveying mode of the stacked body in the embodiment; and

[FIG. 6] is a cross-sectional view showing a stacked body made of a plurality of sheet-shaped molded bodies and a case in a comparative example and working examples 1 and 2; and

[FIG. 7] is a plan view showing a conveying mode of the stacked body in the comparative example and the working examples 1 and 2.

DETAILED DESCRIPTION OF PREFERRED EMBODIMENTS

The same components are denoted by the same reference signs in principle throughout all the drawings for describing the embodiments, and the repetitive description thereof will be omitted. Also, hatching may be used even in a plan view and a side view so as to make the drawings easy to see.

<Silicon Nitride Substrate>

The silicon nitride substrate of the present embodiment is a silicon nitride substrate having two surfaces as its main surfaces, and a silicon nitride substrate having a first main surface as a front surface and a second main surface as a back surface which is an opposite surface is exemplified. Note that the terms "front surface" and "back surface" are used for convenience to distinguish each surface.

The silicon nitride substrate of the present embodiment can be used as, for example, an insulating substrate used in a power module. The power module is, for example, an electronic device configuring an inverter circuit that controls a motor included in an electric vehicle, hybrid electric vehicle, railroad vehicle, or industrial equipment.

<Method of Manufacturing Silicon Nitride Substrate>

Next, a method of manufacturing a silicon nitride substrate of the present embodiment will be described.

(1-1) Preparation of Slurry (Slurry Preparation Step)

First, raw powder is formed by adding a rare earth element oxide and a magnesium compound serving as sintering aids to silicon powder which is a raw material for a substrate, and then, this raw powder is pulverized by a method such as media dispersion to prepare slurry. The raw materials to be used will be described in detail below.

(a) Silicon

As the silicon to be used here, silicon powder of an industrially available grade can be used. The purity of the silicon powder is preferably 99% or higher, and more preferably 99.5% or higher. Impurity oxygen contained in silicon is one of factors that inhibit the thermal conduction of the silicon nitride substrate provided by reaction sintering, and is preferably as small in amount as possible. Also, there is a risk that impurity carbon contained in silicon inhibits the growth of silicon nitride particles in the silicon nitride substrate provided by reaction sintering. As a result, densification becomes insufficient, and this is one of factors that reduce thermal conduction and insulation.

(b) Rare Earth Element Oxide (Sintering Aid)

As the rare earth element oxide to be used here, an oxide of Y, Yb, Gd, Er, Lu, etc., easily available and stable as oxide is preferable. As specific examples of the rare earth element oxides, $Y_2O_3$, $Yb_2O_3$, $Gd_2O_3$, $Er_2O_3$, and $Lu_2O_3$ and the like are exemplified.

(c) Magnesium Compound (Sintering Aid)

As the magnesium compound, one type or two or more types of magnesium compounds containing silicon (Si), nitrogen (N), or oxygen (O) can be used. Particularly, it is preferable to use magnesium oxide (MgO), silicon magnesium nitride ($MgSiN_2$), magnesium silicide ($Mg_2Si$), and magnesium nitride ($Mg_3N_2$), or the like.

(d) Pulverization

The slurry (dispersed raw material powder) is prepared by adding the rare earth element oxide and the magnesium compound serving as the sintering aids to the silicon powder so as to have a predetermined ratio, adding a dispersion medium (organic solvent) and a dispersant as needed, and pulverizing these materials with a ball mill. The types of the dispersion medium and the dispersant are not particularly limited, and can be optionally selected in accordance with the sheet forming method or the like.

As the dispersion medium, ethanol, n-butanol, toluene, methyl ethyl ketone (MEK), methyl isobutyl ketone (MIBK), or the like can be used. As the dispersant, for example, a sorbitan ester type dispersant, a polyoxyalkylene type dispersant or the like can be used.

Time taken for the pulverization is not particularly limited because it varies depending on a milling apparatus to be used, an amount and characteristics of the starting material, and the like. However, it is preferable to select the time so that the raw material powder can be sufficiently pulverized and mixed. The pulverization time is preferably, for example, 6 hours or longer and 48 hours or shorter, and more preferably 12 hours or longer and 24 hours or shorter. If the pulverization time is too short, the silicon nitride substrate with properties required in the present embodiment may not be provided because the pulverization may be insufficient. If the pulverization time is too long, the thermal conductivity of the silicon nitride substrate may decrease because an amount of the impurity oxygen may gradually increase.

(1-2) Preparation of Sheet-Shaped Molded Body (Sheet Molding Step)

Slurry for coating is prepared by adding the dispersion medium, the organic binder, the dispersant, and the like to the provided slurry as needed, performing vacuum defoaming as needed, and adjusting a viscosity within a predetermined range.

The prepared slurry for coating is molded into a sheet shape by using a sheet molding apparatus, is cut to a predetermined size, and is dried to provide the sheet-shaped molded body. The organic binder used for preparing the slurry for coating is not particularly limited, but is exemplified to be PVB-based resin (polyvinyl butyral resin), ethyl cellulose-based resin, acrylic resin or the like. Each adding amount of the dispersion medium, the organic binder, the dispersant, and the like is preferably adjusted appropriately in accordance with the coating conditions. A method of molding the slurry for coating into the sheet shape is not particularly limited. However, for example, a sheet forming method such as a doctor blade method can be used.

The sheet-shaped slurry is then conveyed to a drying chamber set at a predetermined temperature and humidity, is formed to be the dry sheet-shaped molded body by evaporation of the solvent. The sheet provided after the coating is gradually raised in the temperature and is dried when being passed through a drying zone.

A thickness of the sheet-shaped molded body formed in the molding step can be adjusted so that a thickness of the finally resultant silicon nitride substrate becomes the desired thickness that is, for example, 0.15 mm or more and 0.8 mm or less, and the sheet-shaped molded body can be cut to have a desired size by a punching apparatus or the like, as needed.

(1-3) Heating of Molded Body (Heating Step)

By heating the resultant sheet-shaped molded body, the silicon contained in the molded body is nitrided, and then, the molded body is densified. This heating step includes a degreasing step for removing the organic binder from the molded body, a nitriding step for making a reaction for nitriding between silicon (Si) and nitrogen (N) contained in the molded body by heating the sheet molded body under a nitrogen atmosphere, and a sintering step for densification after the nitriding. These steps may be performed sequentially in separate furnaces or may be performed continuously in the same furnace.

In the present embodiment, in this heating step, powdered boron nitride (BN) is applied to the first main surface of the sheet-shaped molded body to form a boron nitride (BN powder) layer. When the plurality of sheet-shaped molded bodies are stacked, this boron nitride (BN) also functions as a separator that makes separation after sintering easy. Therefore, when the plurality of sheet-shaped molded bodies are stacked, boron nitride (BN) is present between the sheet-shaped molded bodies, and each sintered body can be easily separated from the stacked sintered bodies provided after the sintering.

The sheet-shaped molded body coated with the boron nitride powder (BN powder) as described above is placed in an electric furnace, is degreased (the organic binder and the like are removed), and then, is decarbonized in a nitriding treatment furnace at 900°C or higher and 1300°C or lower, is nitrided under a nitrogen atmosphere by increasing its temperature to a predetermined temperature, and then, is sintered in a sintering apparatus. At this time, it is preferable to heat the molded body while applying a load of 10 Pa or more and 1000 Pa or less to the molded body. The degreasing is preferably performed at a temperature of 800°C or lower.

Note that it is preferable to use a BN powder layer with a thickness of about 3 $\mu$m or more and 20 $\mu$m or less as the above-described separator. The BN powder layer can be formed by, for example, spraying, brushing, or screen printing to apply the slurry of the BN powder onto one surface of each sheet-shaped molded body. The BN powder preferably has a purity of 95% or higher and an average particle size (D50) of 1 $\mu$m or more and 20 $\mu$m or less.

Here, the stacked sheet-shaped molded bodies are prepared by overlapping the plurality of sheet-shaped molded bodies so as to be in contact with one another. It is conceivable that the above-described BN powder layer is present between the sheet-shaped molded bodies that are vertically overlapped to form the stacked body. However, in the present application, the stacked body is described as being made of a plurality of sheet-shaped molded bodies stacked to be in contact with one another.

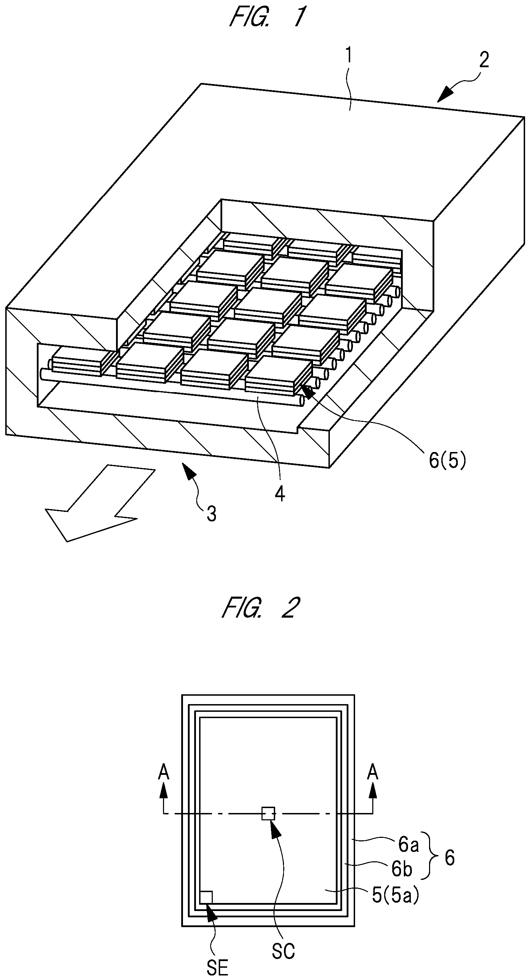

With reference to FIGs. 1 to 5, a configuration of the nitriding treatment furnace and configurations of the sheet-shaped molded bodies and the stacked body thereof that are conveyed in the nitriding treatment furnace will be explained below.

FIG. 1 is a perspective view of the nitriding treatment furnace (continuous heating furnace) 1. In FIG. 1, a part of the nitriding treatment furnace 1 is cut out to show its inside. As shown in FIG. 1, the nitriding treatment furnace 1 has, for example, a cylindrical structure with a rectangular cross section, and includes a conveyor 4 arranged therein for conveying the stacked body 5 made of the sheet-shaped molded bodies in a longitudinal direction of the nitriding treatment furnace 1. The conveyor 4 is made of, for example, a plurality of axially rotatably supported cylindrical rods that are lied down and are arranged in a radial direction (in a direction of the conveyance of the stacked body 5).

The nitriding treatment furnace 1 includes a carry-in port 2 for carrying in the stacked body 5 and a carry-out port 3 for carrying out the stacked body 5. The nitriding treatment furnace 1 also includes a heating unit for heating a space between the carry-in port 2 and the carry-out port 3, and a nitrogen supply unit for supplying nitrogen into the space between the carry-in port 2 and the carry-out port 3. In the nitriding step, the stacked body 5 is carried into the nitriding treatment furnace 1 through the carry-in port 2, is conveyed by the conveyor 4, and is carried out of the nitriding treatment furnace 1 through the carry-out port 3.

While being conveyed as described above, each of the plurality of sheet-shaped molded bodies configuring the stacked body (degreased body) 5 is nitrided by being heated up under nitrogen atmosphere. That is, the stacked body 5 is nitrided by being conveyed from the carry-in port 2 to the carry-out port 3. In order to prevent the temperature decrease in the nitriding treatment furnace 1, each of the carry-in port 2 and the carry-out port 3 may be provided with a shutter that closes except when the stacked body 5 passes through it. In FIG. 1, the direction of the conveyance of the stacked body 5 is illustrated with a white arrow.

In the nitriding step, the nitrogen partial pressure during the nitriding is preferably 0.05 MPa or higher and 0.7 MPa or lower, and more preferably 0.07 MPa or higher and 0.2 MPa or lower. The nitriding temperature is preferably 1350°C or higher and 1500°C or lower, and more preferably 1400°C or higher and 1450°C or lower. The holding time after heating to the nitriding temperature is preferably 3 hours or longer and 12 hours or shorter, and more preferably 5 hours or longer and 10 hours or shorter.

As shown in FIG. 1, a plurality of the stacked bodies 5 are arranged side by side in a first direction (column direction) intersecting with the conveyance direction in a plan view. Here, for example, four stacked bodies 5 are arranged side by side in a direction orthogonal to the conveyance direction in a plan view. When the plurality of stacked bodies 5 that are arranged in the column direction as described above are conveyed, the plurality of stacked bodies 5 can be collectively nitrided. Also, when a plurality of columns of the stacked bodies 5 that are arranged in the column direction as described above are conveyed in the conveyance direction, a large number of the stacked bodies 5 can be continuously nitrided.

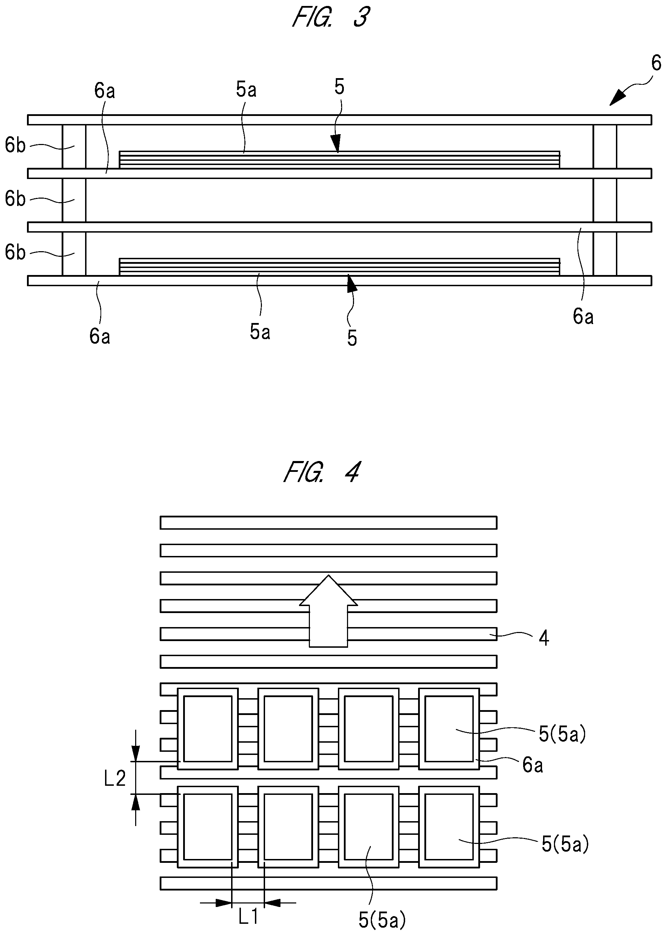

Here, the specific configuration of the stacked bodies 5 that are arranged on the conveyor 4 in FIG. 1 is shown in FIG. 2 and FIG. 3. FIG. 3 is a cross-sectional view taken along a line A-A in FIG. 2. As shown in FIG. 2 and FIG. 3, the stacked body 5 is arranged in a case 6 made of a plate-shaped BN (boron nitride) setter 6a and a BN frame 6b on the BN setter 6a to surround side surfaces of the stacked body 5. That is, while being placed inside the case 6, the stacked body 5 is conveyed on the conveyor 4.

A planar shape of a sheet-shaped molded body 5a configuring the stacked body 5 is a quadrangular shape having a long side (first long side) and a short side (first short side), that is, a rectangular shape. The long side of the sheet-shaped molded body 5a is 100 mm or longer, and the short side of the same is 100 mm or longer. Here, the long side of the sheet-shaped molded body 5a is, for example, 257 mm, and the short side of the same is, for example, 190 mm. A plane-viewed shape of the BN setter 6a is a quadrangular shape having a long side and a short side, that is, a rectangle shape. The long side of the BN setter 6a is, for example, 280 mm, and the short side of the same is, for example, 210 mm.

As shown in FIG. 3, four overlapping BN setters 6a are arranged to separate from one another. Here, one stacked body 5 is placed on a surface of a BN setter 6a at the lowest position, and the other stacked body 5 is placed on a surface of a BN setter 6a at a third position from the bottom. That is, the stacked bodies 5 are stacked at two stages in a plan view. The overlapping stacked bodies 5 are not in contact with each other in a height direction (vertical direction), but are separated from each other to have a predetermined distance therebetween.

One of the main features of the present embodiment is that the number of sheet-shaped molded bodies 5a configuring one stacked body 5 is in a range of 5 or more and 20 or less. Specifically, one stacked body 5 described here is made of 15 sheet-shaped molded bodies 5a stacked in contact with one another in the height direction.

A thickness of one BN setter 6a is, for example, 1 mm or more and 5 mm or less. A thickness of one stacked body 5 is, for example, 7 mm. A distance between the stacked body 5 and the BN setter 6a on it is, for example, 3 mm or more and 23 mm or less. The shortest distance between the BN setters 6a overlapping each other in the height direction, that is, a height of the BN frame 6b, is, for example, 10 mm or more and 30 mm or less.

Here, the stacked body 5 is not placed between a BN setter 6a at a second position from the bottom and a BN setter 6a at a third position from the bottom. One of the main features of the present embodiment is that the shortest distance between the two stacked bodies 5 overlapping in the height direction is 9.0 mm or more and 35.0 mm or less. Specifically, the distance described here is 27 mm.

As described above, in this case, the stacked body 5 made of the plurality of stacked sheet-shaped molded bodies 5a is collectively nitrided. In addition, the plurality of stacked bodies 5 that are overlapped to separate from one another are collectively nitrided. As a result, the number of the sheet-shaped molded bodies 5a to be nitrided per unit time can be increased, and therefore, the manufacturing cost of the silicon nitride substrates can be reduced. The number of stages of the overlapping stacked bodies 5 in this case is two, but may be three or more depending on a space in the nitriding treatment furnace 1. Even in that case, as described above, it is necessary to ensure that the distance between the overlapping stacked bodies 5 is a predetermined distance or more (9.0 mm or more).

As describe above, since the distance between the stacked bodies 5 overlapping in a plan view is set to 9.0 mm or more, this setting can prevent concentration of the reaction heat on the stacked bodies 5 in the heating process of the nitriding step so as not to melt the sheet-shaped molded bodies 5a. Also, since the distance between the stacked bodies 5 overlapping in a plan view is set to 35.0 mm or less, the number of the sheet-shaped molded bodies to be nitrided can be increased even in a nitriding treatment furnace having a relatively low height of an internal space.

In addition, as shown in FIG. 1, the manufacturing cost of the silicon nitride substrates can be reduced by arranging the plurality of stacked bodies 5 side by side in the direction orthogonal to the conveyance direction in a plan view. Here, as shown in FIG. 4, each of the stacked bodies 5 is arranged on the conveyor 4 so that its longitudinal direction is along the conveyance direction (the direction of the white arrow shown in FIG. 4). That is, each of the plurality of stacked bodies 5 arranged in the column direction is conveyed in the direction along its long side direction. As a result, the number of the stacked bodies 5 arranged on the conveyor 4 in the column direction can be maximized (to be four in this case). Therefore, the number of the sheet-shaped molded bodies 5a to be nitrided per unit time can be increased, and thus, the manufacturing cost of the silicon nitride substrates can be reduced.

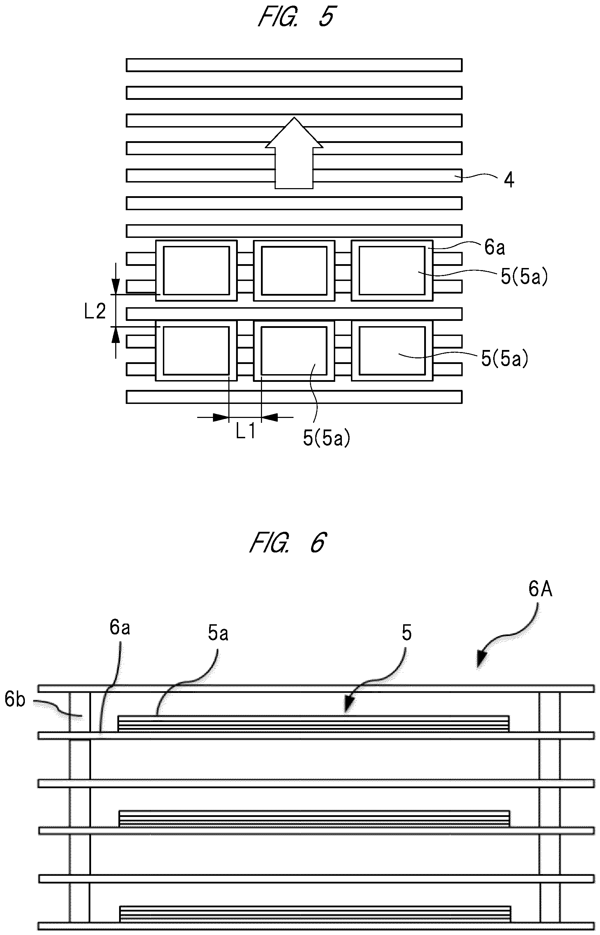

As shown in FIG. 5, it is also conceivable to arrange each stacked body 5 on the conveyor 4 so that its short side direction is along the conveyance direction (the direction of the white arrow shown in FIG. 5). That is, each of the plurality of stacked bodies 5 arranged in the column direction is conveyed in the direction along its short side direction. By arranging the stacked bodies 5 as described above, the number of the stacked bodies 5 arranged in the conveyance direction, that is, the longitudinal direction of the nitriding treatment furnace 1, the column direction on the conveyor 4, can be maximized (to be four in this case). Therefore, since the number of the sheet-shaped molded bodies 5a to be nitrided per unit time can be increased, and thus, the manufacturing cost of the silicon nitride substrates can be reduced.

Even in arrangement of the stacked bodies 5 in either direction shown in FIG. 4 or FIG. 5, a distance L1 between the adjacent stacked bodies 5 in the column direction is 10 mm or more. Also, even in the conveyance direction of the stacked bodies 5, a distance L2 between the adjacent stacked bodies 5 is 10 mm or more. As described above, in a plan view, since the distances L1 and L2 between the stacked bodies 5 adjacent in the conveyance are set to 10 mm or more, this setting can prevent the concentration of the reaction heat on the stacked bodies 5 in the heat treatment of the nitriding step so as not to melt the sheet-shaped molded bodies 5a. The distances L1 and L2 are more preferably set to 100 mm or more. Since the distances L1 and L2 are set to 100 mm or more, this setting can prevent the concentration of the reaction heat on the stacked bodies 5 in the heat treatment of the nitriding step to suppress the melting of the sheet-shaped molded bodies 5a. The distances L1 and L2 are even more preferably set to 200 mm or more. Since the distances L1 and L2 are set to 200 mm or more, this setting can prevent the concentration of the reaction heat on the stacked bodies 5 in the heat treatment of the nitriding step to further suppress the melting of the sheet-shaped molded bodies 5a and suppress the deformation due to expansion of the sheet-shaped molded bodies 5a.

By such a method as described above, the silicon nitride substrate according to the present embodiment is provided. A nitriding rate of the silicon nitride substrate is 90% or more. More specifically, nitriding rates of both a center portion SC and an end portion SE of the silicon nitride substrate in a plan view are 90% or more. Positions of the center portion SC and the end portion SE of the silicon nitride substrate described here correspond to positions of a center portion SC and an end portion SE of the sheet-shaped molding body 5a shown in FIG. 2. The end portion SE is, for example, one of four corners of the quadrangular silicon nitride substrate, that is, a corner portion.

The nitriding rate of the silicon nitride substrate described in the present application is obtained based on the following formula (1) from a silicon content of each 10-mm square specimen in a plan view cut out from a region of each of the center portion SC and end portion SE of the silicon nitride substrate and measured by X-ray analysis.

$$\mathrm{Nitriding\ Rate\ (\%)\ =\ 100\ -\ Silicon\ (wt\%)\ ...(1)}$$

For example, when the measured silicon content is 10 mass%, the nitriding rate is 90%. When the measured silicon content is 0 mass%, the nitriding rate is 100%.

A shape of the silicon nitride substrate provided as described above has, for example, two main surfaces and four side surfaces, and a surface roughness Ra1 of one of the first main surfaces is 0.50 $\mu$m or less.

The shape of the silicon nitride substrate is preferably a quadrangular shape, each side of which is 100 mm or more. A thickness of the silicon nitride substrate is preferably 0.15 mm or more and 0.8 mm or less. The silicon nitride substrate has good thermal conductivity, and is suitable for the applications described above, such as power modules. The thermal conductivity is preferably 100 W/m·K or more, more preferably 110 W/m·K or more, and even more preferably 130 W/m·K or more. The method of manufacturing the silicon nitride substrate including the nitriding step as described in detail above improves the purity of the silicon nitride, and therefore, is preferable because of being capable of easily manufacturing the silicon nitride substrate having the thermal conductivity of 110 W/m·K or more.

By the subsequent sintering step, the stacked body 5 becomes a stacked body of a sintered body in which the sheet-shaped molded bodies 5a are sintered. That is, a silicon nitride substrate that is a plurality of sintered bodies is provided from this stacked body.

The sintered silicon nitride substrate contains $\beta$-phase silicon nitride as a main component, and contains a rare earth element and magnesium. The rare earth element may be in a single state or may form a compound together with other substances. The magnesium contained in the silicon nitride substrate may be in a single state or may be a compound together with other substances.

(1-4) Others

The silicon nitride substrate manufactured as described above preferably has a dense structure with a relative density of 98% or higher. If the relative density of the silicon nitride substrate is lower than 98%, high thermal conductivity cannot be provided. In such a dense silicon nitride substrate, inhibition of thermal conduction due to voids is less likely to occur, and the silicon nitride substrate of the present embodiment particularly preferably has a thermal conductivity of 110 W/m·K or more in the thickness direction.

The thickness of the silicon nitride substrate is not particularly limited, and can be an optional thickness. For example, when the silicon nitride substrate is used as an insulated heatsink substrate of a semiconductor element or an electronic device, its thickness is preferably 0.05 mm or more and 2.5 mm or less, more preferably 0.1 mm or more and 1 mm or less, and even more preferably 0.2 mm or more and 0.7 mm or less especially when it is used as a silicon nitride circuit substrate for power module. A thickness of the sintered silicon nitride substrate can be adjusted to a desired thickness by adjusting the thickness of the sheet-shaped molded body in the sheet molding step, taking into account the influence on the thickness during the sintering.

<Effects of Present Embodiment>

In the nitriding step in the nitriding treatment furnace described with reference to FIG. 1, it is conceivable that, for example, about 45 or more and 90 or less sheet-shaped molded bodies are conveyed into the nitriding treatment furnace and are heated while being stacked in the height direction so that they are in contact with each other. The purpose of increasing the number of the stacked sheet-shaped molded bodies as described above is to increase the number of the sheet-shaped molded bodies to be nitrided per time to reduce the manufacturing cost of the silicon nitride substrates.

However, as explained in the chapter <PROBLEMS TO BE SOLVED BY THE INVENTION>, if the number of the stacked sheets of sheet-shaped molded bodies is too large in the nitriding step as described above, the chain reaction may be caused by the concentration of the reaction heat so as to melt silicon. This causes the problem in the appearance of the silicon nitride substrate to be manufactured and the problem that is insufficiency of the nitriding reaction in the substrate.

It is also conceivable that, after reducing the number of the stacked sheets of the sheet-shaped molded bodies of single stacked body, the stacked bodies that are stacked at two stages while separating from each other in the height direction are conveyed into the nitriding treatment furnace and are nitrided. However, if the two overlapping stacked bodies are too close, the heat may be not released during the nitriding step and melt the silicon.

Accordingly, in the method of manufacturing the silicon nitride substrate of the present embodiment, the number of sheets of the sheet-shaped molded bodies 5a configuring one stacked body 5 is set in a range of 5 or more and 20 or less. In addition, the distance between the stacked bodies 5 overlapping in a plan view is set to 9.0 mm or more. This manner can prevent the concentration of the reaction heat on the stacked bodies 5 in the heat treatment of the nitriding step so as to prevent the melting of the sheet-shaped molded bodies 5a while increasing the number of sheets of sheet-shaped molded bodies to be nitrided per time and reducing the manufacturing cost of the silicon nitride substrates. Therefore, the productivity of the silicon nitride substrates can be improved.

In addition, the plurality of stacked bodies 5 arranged side by side in the direction intersecting with the conveyance direction are nitrided while being conveyed, and at that time, the distance between the adjacent stacked bodies 5 is set to 10 mm or more in a plan view. As a result, this manner can prevent the concentration of the reaction heat on the stacked bodies 5 in the heat treatment of the nitriding step so as to prevent the melting of the sheet-shaped molded bodies 5a while increasing the number of sheets of sheet-shaped molded bodies to be nitrided per time and reducing the manufacturing cost of the silicon nitride substrates.

(Working Examples)

The present embodiment will be described in more detail based on working examples. However, the present invention is not limited to thereto.

(Slurry Preparing Step)

The raw material powder was provided by adding, as the sintering aids, $Y_2O_3$ powder of 1.2 mol% and $MgSiN_2$ powder of 9.8 mol% with respect to a total of the silicon (in conversion to silicon nitride), the rare earth element oxide (in conversion to trivalent oxide) and the magnesium compound (in conversion to MgO) to the silicon powder with a BET specific surface area of 2.1 $m^2$/g, a median diameter D50 of 8.2 um, and an oxygen content of 0.3 mass%. The dispersion medium and the dispersant were added to this raw material powder to provide the slurry with a concentration of 42 mass%, and the slurry was pulverized for 24 hours by using a ball mill and a silicon nitride ball as a medium.
Note that the addition amount of the magnesium compound is expressed in unit of "mol%" when all magnesium compounds are converted to MgO. The BET specific surface area of the silicon powder before the pulverization, the median diameter D50, and the oxygen content were measured using a BET specific surface area meter of the BET single-point method, a particle size distribution meter of a laser diffraction and scattering method, and an oxygen analyzer of the inert gas fusion-nondispersive infrared absorption method, respectively.

(Sheet Molding Step)

The dispersion medium and the organic binder (acrylic resin) were added to the resultant slurry to adjust a concentration, and the slurry was defoamed to form a slurry-like coating solution. The coating slurry was applied onto a conveying film by the doctor blade method, and the film was molded at a molding speed of 600 mm/min or less into a sheet shape with a thickness of 0.38 mm, and was cut to have a size of "257 mm × 191 mm" to provide the sheet-shaped molded body.

(Nitriding Step)

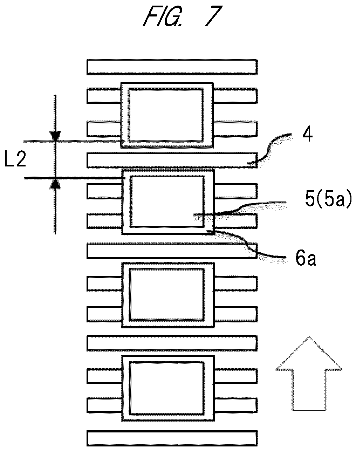

The boron nitride (BN powder) layer is formed on a main surface of the resultant sheet-shaped molded body. The stacked body 5 in which 15 sheet-shaped molded bodies are stacked to sandwich the boron nitride powder (BN powder) layer (with a thickness of 4.5 $\mu$m) therebetween was prepared. In a comparative example and working examples 1 and 2, as shown in FIG. 6, the case 6A is configured so that six BN setters 6A are stacked to separate from one another. Here, the first stacked body 5 is placed on the surface of the BN setter 6a at the lowest position, the second stacked body 5 is placed on the surface of the BN setter 6a at the third position from the bottom, and the third stacked body 5 is placed on the surface of the BN setter 6a at the fifth position from the bottom. That is, the stacked bodies 5 are stacked at three stages in a plan view. The stacked bodies 5 are not in contact with one another in the height direction (vertical direction), and separate by a distance of 28 mm from one another.
The nitriding treatment furnace shown in FIG. 1 was used, the stacked bodies 5 of the comparative example and the working examples 1 and 2 were arranged as shown in FIG. 7, and were degreased and nitrided as described below. The stacked bodies were designed as a stacked body (1), a stacked body (2), a stacked body (3), and a stacked body (4), in an order from the carry-in port side of the nitriding treatment furnace. Also, in the conveyance direction of the stacked bodies 5, the distance L2 between the adjacent stacked bodies 5 was set to 10 mm in the comparative example, 100 mm in the working example 1, and 200 mm in the working example 2. Note that the used nitriding treatment furnace was configured so that a plurality of regions are set in the nitriding treatment furnace. The nitriding treatment furnace was 330 mm wide, 7200 mm deep, and 110 mm high, and was divided into 16 regions, each length of which is 450 mm, so that first to thirteenth regions (zones 1 to 13) counted from the carry-in side are set as the heating regions while fourteenth to sixteenth regions (zones 14 to 16) therefrom are set as the cooling regions. Here, each of the zones 1 to 16 is provided with a nitrogen gas supply piping, and each of the zones 1 to 7 is provided with an internal atmosphere discharge piping. The supply piping was arranged below the apparatus while the discharge piping was arranged above the apparatus so that each of the supply piping and the discharge piping causes the countercurrent flow to the conveyance direction of the sheet-shaped molded bodies.
The zones 1 to 13 are provided with an SiC heater as the heating unit of the nitriding treatment furnace and are provided with a roller conveyor as the conveying mechanism.
By use of this nitriding treatment apparatus, the nitriding treatment was performed under the conditions shown in Table 1. At this time, the holding time indicated the holding time at the nitriding temperature, and the pressure in the furnace was kept at 15 to 20 Pa. Also, the oxygen concentration in the nitriding treatment furnace was controlled to 1 ppm or less at all times.

[Table 1] distance L2

|  | Nitriding temperature (° C) | Nitriding time (h) | Gaseous species | Oxygen concentration (ppm) | Gas flowrate (L/min) | | Distance L2 (mm) |
|---|---|---|---|---|---|---|---|
|  |  |  |  |  | $N_2$ | $H_2$ |  |
| Comparative example | 1400 | 5 | N2+3%H2 | 1 > | 500 | 15 | 10 |
| Working example 1 | 1400 | 5 | N2+3%H2 | 1 > | 500 | 15 | 100 |
| Working example 2 | 1400 | 5 | N2+3%H2 | 1 > | 500 | 15 | 200 |

The evaluation results of the sheet-shaped molded body (nitrided body) provided after the nitriding step are collectively shown in a table 2. The nitrided body was observed in appearance to check whether melting of silicon had occurred. That is, a white part is defined as a state in which the silicon nitriding was completed to provide the silicon nitride, and a black part is defined as a state in which the silicon was melted to prevent the completion of the nitriding. In the table 2, "O" indicates that the black part due to the melting of the silicon was not observed in any of the 15 stacked nitrided bodies at each stage of each stacked body, "△" indicates that a ratio of the black part with respect to the surface area of the nitrided bodies is 1% or lower, and "×" indicates that the ratio of the black part with respect to the surface area of the nitrided bodies is higher than 1%. Also, the appearance of the nitrided bodies was observed to check if swelling had occurred. That is, a protruding part with a height of 100 um or more with respect to the nitrided body surface is defined as a swelling. In the table 2, "O" indicates that the protruding part due to the swelling was observed in any of the 15 stacked nitrided bodies at each stage of each stacked body, "△" indicates that a ratio of the protruding parts with respect to the surface area of the nitrided bodies is 5% or lower, and "×" indicates that the ratio of the protruding parts with respect to the surface area of the nitrided bodies is higher than 5%.

[Table 2]

|  |  | Stacked body 1 | | Stacked body 2 | | Stacked body 3 | | Stacked body 4 | |
|---|---|---|---|---|---|---|---|---|---|
|  |  | Si melting | Swelling | Si melting | Swelling | Si melting | Swelling | Si melting | Swelling |
| Comparative example | First stage | × | × | × | × | × | △ | △ | × |
|  | Second stage | △ | △ | △ | △ | × | △ | △ | × |
|  | Third stage | × | × | × | × | × | △ | △ | △ |
| Working example 1 | First stage | O | × | O | × | O | O | O | O |
|  | Second stage | O | O | O | O | O | O | O | O |
|  | Third stage | O | O | O | O | O | O | O | O |
| Working example 2 | First stage | O | △ | O | O | O | O | O | △ |
|  | Second stage | O | O | O | O | O | O | O | O |
|  | Third stage | O | O | O | O | O | O | O | O |

In the comparative example, the silicon melting and the deformation due to the swelling of the substrate were observed in the stacked bodies (1) to (4). In the working example 1, the silicon melting was not observed in the stacked bodies (1) to (4), and the swelling of the nitrided body was observed at the first stage of the stacked bodies (1) and (2). In the working example 2, the silicon melting was not observed in the stacked bodies (1) to (4), and the slight swelling of the substrate was observed at the first stage of the stacked bodies (1) and (4).

Accordingly, from the viewpoint of suppressing the silicon melting, the distance between the adjacent stacked bodies 5 is set to 100 mm or more. Also, the distance between the adjacent stacked bodies 5 is more preferably 200 mm or more from the viewpoint of suppressing the silicon melting and suppressing the deformation due to the swelling of the nitrided body.

In the foregoing, the invention made by the inventors of the present application has been concretely described on the basis of the embodiments. However, it is needless to say that the present invention is not limited to the foregoing embodiments, and various modifications can be made within the scope of the present invention.

The present invention can be widely used in the method of manufacturing the silicon nitride substrate.

Explanation of Reference Characters

1 nitriding treatment furnace (continuous heating furnace)
2 carry-in port
3 carry-out port
4 conveyor
5 stacked body
5a sheet-shaped molded body
6 case
6a BN setter
6b BN frame

**Claims**

1. A method of manufacturing a silicon nitride substrate, comprising a step of:

    nitriding a stacked body made of 5 or more and 20 or less stacked sheet-shaped molded bodies each having a sheet shape and containing silicon by conveying the stacked body from a carry-in port to a carry-out port in a continuous heating furnace including the carry-in port, the carry-out port, a heating unit for heating a space between the carry-in port and the carry-out port, and a nitrogen supply unit for supplying nitrogen into the space between the carry-in port and the carry-out port,
    wherein a plurality of the stacked bodies are conveyed while being arranged side by side in a first direction intersecting with a conveyance direction in a plan view, and
    a distance between the adjacent stacked bodies during the conveyance is 100 mm or more in a plan view.

2. The method of manufacturing the silicon nitride substrate according to claim 1,

    wherein a plurality of the stacked bodies are stacked in a height direction, and
    a distance in the height direction between the overlapping stacked bodies is 9.0 mm or more.

3. The method of manufacturing the silicon nitride substrate according to claim 1,

    wherein a planar shape of the stacked body is a quadrangular shape having a first long side and a first short side, and
    each of the plurality of the stacked bodies that are arranged side by side in the first direction is conveyed in a direction along the first long side.

4. The method of manufacturing the silicon nitride substrate according to claim 1,

    wherein a planar shape of the stacked body is a quadrangular shape having a first long side and a first short side, and
    each of the plurality of the stacked bodies that are arranged side by side in the first direction is conveyed in a direction along the first short side.

5. The method of manufacturing the silicon nitride substrate according to claim 1,

    wherein a planar shape of the stacked body is a quadrangular shape having a first long side and a first short side, and

a length of the first short side is 100 mm or more.

6. The method of manufacturing the silicon nitride substrate according to claim 1,
   wherein a thickness of the sheet-shaped molded body is 0.05 mm or more and 2.5 mm or less.

7. The method of manufacturing the silicon nitride substrate according to claim 1,
   wherein a plurality of stacked sintered bodies are provided by sintering the stacked nitrided body.

8. The method of manufacturing the silicon nitride substrate according to claim 1,
   wherein a nitriding rate of the nitrided sheet-shaped molded body is 90% or higher.

9. The method of manufacturing the silicon nitride substrate according to claim 7,

   wherein a planar shape of the sintered body is a quadrangular shape having a second long side and a second short side, and
   a length of the second short side is 100 mm or more.

10. The method of manufacturing the silicon nitride substrate according to claim 7,
    wherein a thickness of the sintered body is 0.15 mm or more and 0.8 mm or less.

*FIG. 1*

*FIG. 2*

FIG. 3

FIG. 4

FIG. 5

FIG. 6

## FIG. 7

## INTERNATIONAL SEARCH REPORT

| International application No. |
|---|
| **PCT/JP2023/013362** |

### A. CLASSIFICATION OF SUBJECT MATTER

*C04B 35/587*(2006.01)i; *C01B 21/06*(2006.01)i; *C04B 35/64*(2006.01)i; *H05K 1/03*(2006.01)i
FI:  C04B35/587; C01B21/06 N; H05K1/03 610D; C04B35/64

According to International Patent Classification (IPC) or to both national classification and IPC

### B. FIELDS SEARCHED

Minimum documentation searched (classification system followed by classification symbols)

C04B35/587; C01B21/06; C04B35/64; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | US 2006/0087060 A1 (VOILES, Edwin Todd) 27 April 2006 (2006-04-27) paragraphs [0009]-[0011], [0018] | 1-10 |
| A | WO 2022/004755 A1 (TOKUYAMA CORP.) 06 January 2022 (2022-01-06) entire text, all drawings | 1-10 |
| A | JP 11-201658 A (MURATA MANUFACTURING CO., LTD.) 30 July 1999 (1999-07-30) entire text, all drawings | 1-10 |
| A | JP 6-100303 A (DENKI KAGAKU KOGYO K.K.) 12 April 1994 (1994-04-12) entire text, all drawings | 1-10 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | |
| "O" | document referring to an oral disclosure, use, exhibition or other means | "Y" | document of particular relevance; the claimed invention cannot be considered to involve an inventive step when the document is combined with one or more other such documents, such combination being obvious to a person skilled in the art |
| "P" | document published prior to the international filing date but later than the priority date claimed | "&" | document member of the same patent family |

| Date of the actual completion of the international search | Date of mailing of the international search report |
|---|---|
| **13 June 2023** | **27 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2023/013362**

| Patent document cited in search report | | | Publication date (day/month/year) | Patent family member(s) | | | Publication date (day/month/year) |
|---|---|---|---|---|---|---|---|
| US | 2006/0087060 | A1 | 27 April 2006 | (Family: none) | | | |
| WO | 2022/004755 | A1 | 06 January 2022 | CN entire text, all drawings TW | 115702130 202208308 | A A | |
| JP | 11-201658 | A | 30 July 1999 | (Family: none) | | | |
| JP | 6-100303 | A | 12 April 1994 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015199657 A